# EUROPÄISCHE PATENTSCHRIFT

(11) **EP 0 700 095 B1**
(45) Veröffentlichungstag und Bekanntmachung des Hinweises auf die Patenterteilung: **26.03.2003**
(21) Anmeldenummer: 95810516.5
(22) Anmeldetag: 16.08.1995
(51) Int. Cl.: H01L 29/744

(54) **Abschaltbarer Thyristor für hohe Blockierspannungen und kleiner Bauelementdicke**
Gate-turn-off-thyristor with high blocking voltage and small device thickness
Thyristor à blocage par gâchette à haute tension de blocage et ayant une petite épaisseur de dispositif

(30) Priorität: 02.09.1994 DE 4431294
(43) Veröffentlichungstag der Anmeldung: 06.03.1996
(73) Patentinhaber: ABB Schweiz AG, 5400 Baden (CH)
(72) Erfinder: Bauer, Friedhelm, Dr., CH-5034 Suhr (CH); Eicher, Simon, CH-8003 Zürich (CH)
(74) Vertreter: ABB Patent Attorneys

(56) Entgegenhaltungen:
- EP-A- 0 391 337
- EP-A- 0 621 640
- GB-A- 2 130 028
- PATENT ABSTRACTS OF JAPAN vol. 16, no. 185 (E-1197), 6. Mai 1992 & JP 04 023438 A (NIPPON INTERELECTRONICS CORP), 27. Januar 1992
- TSUNEO OGURA: "6000-V GATE TURN-OFF THYRISTORS (GTO'S) WITH N-BUFFER AND NEW ANODE SHORT STRUCTURE" IEEE TRANSACTIONS ON ELECTRON DEVICES, Bd. 38, Nr. 6, 1. Juni 1991, Seiten 1491-1496, XP000205847
- M, AYMAN SHIBIB ET AL.: "Heavily doped transparent-emitter regions in junction solar cells, diodes, and transistors " IEEE TRANSACTIONS ON ELECTRON DEVICES., Bd. ED-26, Nr. 6, Juni 1979, Seiten 959-965, XP002101882 NEW YORK US

## Beschreibung

### Technisches Gebiet

Die Erfindung bezieht sich auf das Gebiet der Leistungshalbleiter. Sie geht aus von einem abschaltbaren Thyristor (Gate Turn Off Thyristor GTO) nach dem Oberbegriff des ersten Anspruchs.

### Stand der Technik

Ein solcher GTO ist aus zahlreichen Veröffentlichungen bekannt. Es handelt sich dabei um einen klassischen GTO, wie er beispielsweise in der Europäischen Patentschrift EP-B1-0 159 797 beschrieben wird. Ein derartiger ausschaltbarer Thyristor umfasst zwischen einer anodenseitigen und einer kathodenseitigen Hauptfläche von der Anode her einen p+ dotierten Anodenemitter, eine n-Basis, eine p-Basis und n+ dotierte Kathodengebiete. Die Kathodengebiete werden von der Kathode kontaktiert, und die p-Basis von einer Gateelektrode, mittels welcher das Bauelement ein- und ausgeschaltet werden kann.

Zur Verbesserung der elektrischen Eigenschaften der GTOs können im Anodenemitter Anodenkurzschlüsse vorgesehen werden. Diese Massnahme wird beispielsweise in der Europäischen Patentanmeldung EP-A1-0 327 901 beschrieben.

Solche GTOs sind heute zentraler Bestandteil moderner Umrichterantriebe im Hochleistungsbereich. Es hat sich weitgehend ein Stand der Technik der Bauelement sowie ihrer Beschaltung und Ansteuerung eingestellt. Die diversen Anbieter setzen hierbei alle auf das gleiche fundamentale Konzept eines GTOs: Bei maximal erlaubter Blockierspannung reicht die Verarmungszone etwa 100 µm bis 200 µm vor der Anode in den quasineutralen, nicht verarmten Bereich der n-Basis. Diese Struktur wird allgemein mit dem englischen Fachwort "non-punchtrough" Konzept (NPT-Konzept, NPT GTO) bezeichnet. In der Praxis werden deshalb für Bauelemente mit 4.5 kV Blockierspannung Substrate mit einer Dicke von etwa 800 µm benötigt. Diese Dicke erlaubt mit nur geringen Unterschieden bei verschiedenen Anbietern eine maximale Schaltfrequenz von 300 Hz bis 500 Hz. Die absolute Höhe dieser Frequenz ist durch die anfallenden Schaltverluste und die physikalischen Grenzen der Wärmeabfuhr durch Kühlung gegeben.

Bei den Anwendern geht der Trend aus verschiedenen Gründen jedoch in Richtung höherer Schaltfrequenzen. Ein Grund liegt in der Forderung nach einer Verminderung der Oberwellen in den Spannungsversorgungsnetzen. Das NPT-Konzept ist aber bereits weitgehend ausgereizt, so dass signifikante Verbesserungen bezüglich der erzielbaren Schaltfrequenzen kaum mehr zu erwarten sind.

Wird jedoch eine anodenseitige Stopschicht eingeführt, so ist es möglich, ein Substrat mit niedriger Grunddotierung zu benutzen. Bei einer solchen Struktur wird die Ladung während des Abschaltens vom Feld aus dem Bauelement gedrückt. Im Gegensatz zum Non-Punchthrough Konzept (NPT) spricht man deshalb hier von einem Punchthrough Konzept (PT). Dies wird für eine SiTh (Static Induction Thyristor) im Amerikanischen Patent US, 5,001,535 beschrieben. Führt man bei einem solchen PT Konzept aber noch die ansonsten vorteilhaften Anodenkurzschlüsse ein, wie dies in der japanischen Patentanmeldung 2126606 gezeigt ist, welche ein Verfahren für eine hochpräzise Herstellung der Anodenkurzschlüsse beschreibt, so werden diese aufgrund der erhöhten Dotierung der Stopschicht extrem effizient. EP 391337 zeigt, wie für einen GTO, in welchem PT Konzept und Anodenkurzschlüsse kombiniert sind und welcher eine Anzahl von n-Emitter-Regionen aufweist, die in radialer Richtung in mehreren ringförmigen Bereichen angeordnet sind, ein über die mehreren Bereiche homogenes Schaltverhalten erzielt und damit eine Zündsicherheit erhöht werden kann. Insgesamt hat sich jedoch herausgestellt, dass ein niedriger Durchlass und sicheres Zünden für derartige Bauelemente nur möglich sind, wenn der Anteil der kurzgeschlossenen Anodenfläche im Bereich von 1% bis 3% liegt. Experimente haben gezeigt, dass dann aber die Abschaltverluste auf ein nicht mehr akzeptables Niveau steigen.

Diese Problematik geht auch aus dem Artikel "*6000V Gate Turn-Off Thyristors with n-Buffer and New Anode Short Structure"* in IEEE Transactions on Electron Devices, **38** (1991), p. 1491-1496 von T. Ogura et al. hervor. Dort wird untersucht, welchen Einfluss eine Anzahl und damit ein Flächenanteil der Anodenkurzschlüsse auf Abschaltverluste, benötigten Zündstrom (gate triggering current) und Durchlassspannung haben. Auch hier zeigt sich, dass für eine Minimierung des benötigten Zündstroms die Anzahl der Anodenkurzschlüsse möglichst klein zu wählen wäre, dies aber zu einem starken Anstieg der Abschaltverluste führt.

Eine Erhöhung der Schaltfrequenz kann also durch eine einfache Kombination von PT Konzept und Anodenkurzschlüssen in einem GTO nicht erreicht werden.

Dies ist auch der Grund, weshalb für GTOs das Punchthrough Konzept von keinem Anbieter zur Serienreife entwickelt worden ist.

### Darstellung der Erfindung

Aufgabe der vorliegenden Erfindung ist es, einen GTO anzugeben, bei welchem die Schaltfrequenz erhöht werden kann ohne dass die Schaltverluste ansteigen und dessen Substratdicke verringert werden kann.

Diese Aufgabe wird bei einem GTO der eingangs genannten Art durch die Merkmale des ersten Anspruchs gelöst.

Kern der Erfindung ist es also, dass eine Kombination eines transparenten, mit Anodenkurzschlussgebieten durchsetzten Anodenemitters mit einer Stopschicht vorgesehen wird.

Ein transparenter Emitter wird schon für Bauelemente geringer Leistung wie Solarzellen, Dioden oder Transistoren eingesetzt (siehe z.B. IEEE Transactions on Electron Devices, Vol. ED-26, No. 6, Juni 1979, Seiten 959-965). Wie dort beschrieben wird, ist ein transparenter Emitter durch die Bedingung definiert, dass die Transitzeit τₜ der Minoritätsladungsträger deutlich kleiner ist als die Lebensdauer τₚ ebendieser der Minoritätsladungsträger im Emitter, d.h. τₜ << τₚ. Mit anderen Worten können in diesem Fall überschüssige Minoritätsladungsträger, welche in den Emitterbereich der p-n-Grenzschicht injiziert werden, den quasineutralen Emitterbereich ohne nennenswerte Rekombination überqueren. Der Emitter ist somit transparent für die injizierten Minoritätsladungsträger, was bedeutet, dass hohe Anteile des kathodenseitigen Elektronenstroms rekombinationsfrei, also ohne Auslösung eines injizierten Loches extrahiert werden können. Aus diesem Grund versteht man unter einem transparenten Anodenemitter kurz gesagt einen anodenseitigen Emitter mit vergleichsweise schwacher Injektion.

Entgegen der allgemeinen Fachmeinung, die für einen PT GTO mit transparentem Emitter infolge der Transparenz eine schlechte Zündempfindlichkeit vermutete, konnte im Rahmen der vorliegenden Erfindung durch intensive Simulationen und Versuche nachgewiesen werden, dass die Kombination von Anodenkurzschlüssen im transparenten Emitter mit der Stopschicht zu überraschend guten Ergebnissen führt. Entgegen der ursprünglichen Annahme stellte sich heraus, dass auch ein transparenter Emitter im Bereich kleiner Stromdichten beim Zünden eine annähernd gleich hohe Injektionseffizienz bietet wie ein konventioneller Emitter.

Der Grund hierfür liegt in der Zündbedingung des GTOs: Aus der Theorie der Thyristoren ist bekannt, dass die Zündbedingung eines regenerativen Bauelementes im wesentlichen durch die Summe der Stromverstärkungen der partiellen Teiltransistoren gegeben ist. wegen der Abhängigkeit der Stromverstärkungen von der Anodenstromdichte sind diese nicht konstant. Für einen konventionellen, kommerziell erhältlichen NPT GTO zeigt die Summe der Stromverstärkungen in Abhängigkeit der Anodenstromdichte einen annähernd konstanten Verlauf mit einer ausgeprägten Zündschwelle, ab welcher die Summe steil ansteigt. Diese Zündschwelle tritt z.B. bei ca. 0.07 A/cm2 auf. Ein GTO mit transparentem Anodenemitter zeigt dagegen ein anderes Verhalten: Die Summe der Stromverstärkungen steigt ungefähr linear mit zunehmender Anodenstromdichte an. Eine Zündschwelle ist nicht auszumachen. Dadurch ergeben sich beim Einschalten Probleme, denn nur eine ausgeprägte Zündschwelle gewährleistet homogenes Einschalten über den gesamten Querschnitt.

Erst durch das Einfügen von Emitterkurzschlüssen bildet sich wieder eine ausgeprägte Zündschwelle aus. Dies konnte durch umfangreiche Simulationen und Versuche nachgewiesen werden.

Somit erreicht man erst durch die erfindungsgemässe Kombination von transparentem, mit Anodenkurzschlüssen durchsetztem Emitter mit einer Stopschicht das gewünschte Verhalten.

Im Gegensatz zu Anodenkurzschlüssen nach dem Stand der Technik, mittels welchen die Effizienz des Emitters eingestellt wird, dienen die Anodenkurzschlüsse nach der Erfindung der Definition einer ausgeprägten Zündschwelle; die Effizienz des Emitters wird hingegen durch seine Transparenz gesteuert.

Ein bevorzugtes Ausführungsbeispiel zeichnet sich dadurch aus, dass die Stopschicht eine Tiefe von ca. 20 µm bis 40 µm und eine Dotierungs-Randkonzentration von ca. 7*10¹⁴ cm⁻³ aufweist. Weiter kann die Stopschicht entweder durch Eindiffusion oder Epitaxie hergestellt werden.

Von besonderem Vorteil ist eine epitaktisch gewachsene Stopschicht mit einem zweistufigen Dotierungsprofil. Ein Bereich mit niedrigerer Dotierungkonzentration wird direkt an den Anodenemitter angrenzend vorgesehen. Auf diese Weise ist sichergestellt, dass der Anodenkurzschluss einen sehr niedrigen Querleitwert in der Stopschicht erfährt.

Die Anodenkurzschlüsse werden vorzugsweise mit einem relativ kleinen Querschnitt von ca. 5 bis 10 µm ausgeführt. Dadurch erhält man einen optimalen Zündstrom von ca. 300 mA.

Weitere Ausführungsbeispiele ergeben sich aus den entsprechenden abhängigen Ansprüchen.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Einen Ausschnitt eines erfindungsgemässen Thyristors im Schnitt.
- **Fig. 2a-c**: Drei Beispiele von Dotierungsprofilen der Stopschicht.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

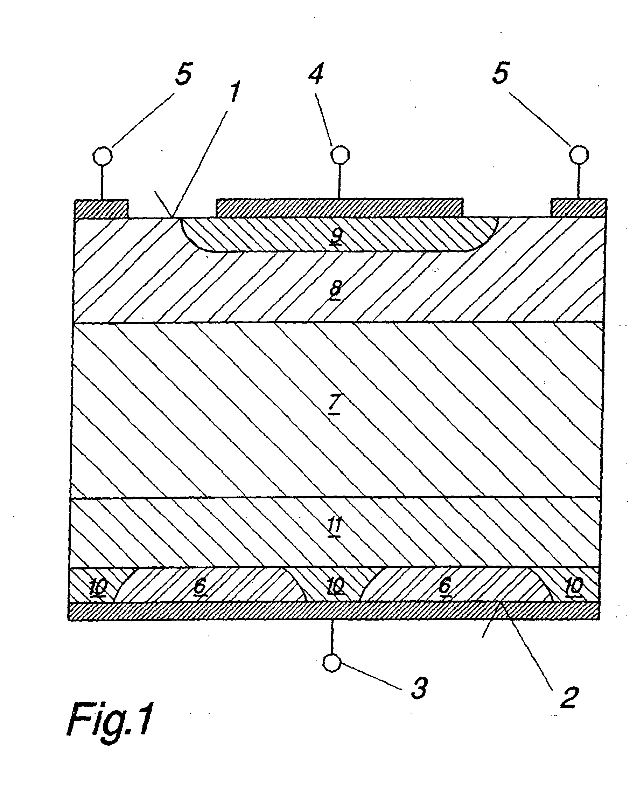

**Figur 1** zeigt einen Ausschnitt eines erfindungsgemässen GTOs im Schnitt. Allgemein sind p-dotierte Gebiete mit von oben rechts nach unten links verlaufenden Doppellinien und n-dotierte Gebiete mit von oben links nach unten rechts verlaufenden, einfachen Linien schraffiert. Die Dichte der Schraffierung ist abhängig von der Dotierungskonzentration, wobei höher dotierte Gebiete enger schraffiert sind. Metallisierungen sind mit von oben rechts nach unten links dicht verlaufenden Linien schraffiert.

Ein erfindungsgemässer GTO umfasst zwischen einer ersten Hauptfläche 1 und einer zweiten Hauptfläche 2 ein Anzahl von unterschiedlich dotierten Halbleiterschichten 6-9. Von der zweiten Hauptfläche 2 her gesehen sind dies ein p+ dotierten Anodenemitter 6, eine n dotierte n-Basis 7, eine p dotierte p-Basis 8 und ein n+ dotierter Kathodenemitter 9. Der Anodenemitter 6 wird von einer Anodenmetallisierung, welche eine Anodenelektrode 3 bildet, kontaktiert; der Kathodenemitter 9 von einer entsprechenden Kathodenelektrode 4. Der Kathodenemitter 9 ist in die p-Basis 8 eingelassen, so dass die p-Basis 8 teilweise an die erste Hauptfläche 1 tritt. Dort wird die p-Basis 8 von einer Gateelektrode 5, gebildet durch eine entsprechende Metallisierung, kontaktiert. Mittels Anlegen einer Steuerspannung an die Gateelektrode 5 kann der Stromfluss durch den GTO ein- und ausgeschaltet werden. Dieser Mechanismus ist hinlänglich bekannt und bedarf keiner weiteren Erläuterung.

Nach der Erfindung ist der Anodenemitter 6 transparent, das heisst er weist eine vergleichsweise schwache Injektion auf, so dass hohe Anteile des von der Kathode kommenden Elektronenstroms rekombinationslos und damit ohne Auslösung eines injizierten Loches extrahiert werden kann. Dies erreicht man dadurch, dass der Anodenemitter 6 vergleichsweise schwach dotiert und dünn ist. Im Rahmen der Erfindung wird beispielsweise eine Tiefe von ca. 1.2 µm und eine Dotierung von 10¹⁸ cm⁻³ bevorzugt.

Diesem transparenten Anodenemitter 6 ist eine Stopschicht 11 vorgelagert. Die Stopschicht 11 ist stärker dotiert als die n-Basis 7, so dass das anodenseitige Feld in der Stopschicht 11 begrenzt wird. Vorzugsweise weist die Stopschicht 11 eine Tiefe von ca. 20 µm bis 40 µm und eine Dotierungsrandkonzentration von ca. 7*10¹⁴ cm⁻³ auf.

Der transparente Emitter ist weiterhin durchsetzt mit Anodenkurzschlüssen 10. Diese sind noch höher dotiert als die Stopschicht 11. Die Anodenkurzschlüsse 10 sorgen dafür, dass sich im Bauelement eine ausgeprägte Zündschwelle einstellt.

Die Kombination von transparentem Emitter, Anodenkurzschlüssen und Stopschicht ermöglicht also die Realisierung der geforderten Eigenschaften wie höhere Schaltfrequenz, dünneres Substrat und keine Erhöhung der Schaltverluste.

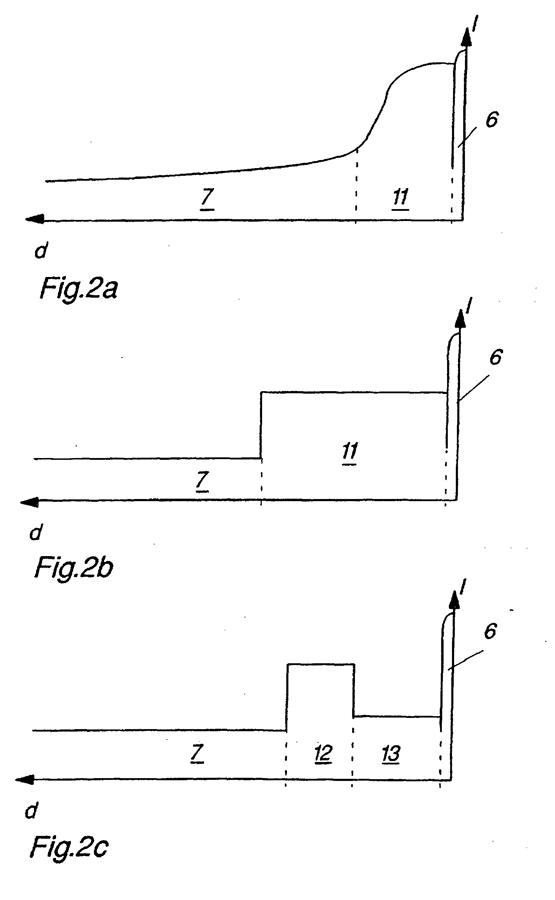

Damit der Zündstrom nicht allzu gross wird, weisen die Anodenkurzschlüsse 10 nach Erfindung nur einen relativ geringen Durchmesser auf. Bevorzugt werden Werte zwischen 5 µm und 10 µm. Die Stopschicht 11 kann auf zwei Arten erzeugt werden: entweder durch Diffusion oder durch Epitaxie. Epitaktisch hergestellte Stopschichten bieten einen weiteren Vorteil: Bei diffundierten Stopschichten weist das Dotierungsprofil angenähert eine Guass'sche Verteilung auf (siehe **Figur 2a**). Bei epitaktisch gewachsenen Stopschichten ist die Dotierung homogen über die Schichtdicke. Sie kann deshalb viel präziser als ein eindiffundiertes Profil eingestellt werden (siehe **Figuren 2b und 2c**). Dadurch kann die Tiefe der Stopschicht reduziert und die Substratdicke verkleinert werden. Denn aufgrund der homogenen Dotierung kann die Ladung effektiver zur Begrenzung des anodenseitigen elektrischen Feldes eingesetzt werden.

Es wird aber auch möglich, eine Stopschicht mit mehrstufigem Dotierungsprofil herzustellen. Insbesondere wenn die an den Anodenemitter 6 grenzende Stufe 13 schwächer dotiert ist als die davon weiter entfernte Stufe 12, können die Anodenkurzschlüsse 10 mit grösseren Durchmessern versehen werden. Dadurch sind sie einfacher herzustellen. Es ist aber dennoch gewährleistet, dass die Anodenkurzschlüsse in der direkt anschliessenden, niedriger dotierten Stufe 13 einen hinreichend niedrigen Querleitwert in der Stopschicht 11 erfährt. Der Feldabbau in der Stopschicht 11 wird durch die höher dotierte Stufe 12 übernommen.

Die höher dotierte Stufe 12 weist vorzugsweise eine Dotierung von ca. 10¹⁵ cm⁻³ und eine Tiefe von ca. 10 µm auf. Für die Stufe 13 wurde eine Dotierung von weniger als 10¹⁴ cm⁻³ und eine Tiefe von ca. 10 µm gewählt.

Diese mehrstufige Stopschicht 11 bietet aber noch einen weiteren Vorteil: Die höher dotierte Stufe 12 dämpft kleine Potentialschwankungen, die durch die Existenz der Anodenkurzschlüsse 10 bedingt sind und eine signifikante Modulation des Plasmas im Bereich der Kurzschlüsse verursachen. Ein weiterer Vorteil dieser mehrstufigen Struktur besteht darin, dass die Dotierung von 10¹⁵ cm⁻³ der Stufe 12 zusammen mit der Tiefe von ca. 10 µm sicherstellt, dass auch sehr hohe elektrische Felder abgebaut werden können. Dies wäre bei einem GTO nach dem Stand der Technik nur durch eine Erhöhung der Ladung in der Stopschicht und den damit verbundenen Nachteilen für die Zündeigenschaften bzw. den Durchlass möglich. Ohne Anpassung der Stopschicht wie beschrieben würde beim Anlegen der maximalen Blockierspannung oder sogar bereits früher der "punchthrough" drohen.

Insgesamt kann gesagt werden, dass die erfindungsgemässe Kombination von Stopschicht, Anodenkurzschlüssen und transparentem Emitter ermöglicht einen GTO herzustellen, der bei höheren Schaltfrequenzen betrieben werden kann, ein dünneres Substrat aufweist und dessen Durchlassverluste dennoch nicht ansteigen. Durch Variation der Tiefe der Stopschicht und deren Dotierung können wie erläutert noch weitere Vorteile erreicht werden.

### Bezeichnungsliste

- 1: erste Hauptfläche
- 2: zweite Hauptfläche
- 3: Anodenelektrode
- 4: Kathodenelektrode
- 5: Gateelektrode
- 6: Anodenemitter
- 7: n-Basis
- 8: p-Basis
- 9: Kathodenemitter
- 10: Anodenkurzschlüsse
- 11: Stopschicht
- 12: erste Stufe
- 13: zweite Stufe
- I: Dotierungsdichte
- d: Abstand von der zweiten Hauptfläche

## Patentansprüche

1. Abschaltbarer Thyristor umfassend:
a) zwischen einer ersten Hauptfläche (1) und einer zweiten Hauptfläche (2) eine Anzahl von unterschiedlich dotierten Halbleiterschichten (6-9);
b) auf der zweiten Hauptfläche (2) eine Anodenelektrode (3) sowie auf der ersten Hauptfläche (1) eine Kathodenelektrode (4) und eine Gateelektrode (5); wobei
c) die Halbleiterschichten (6-9) von der zweiten Hauptfläche (2) her gesehen einen p+ dotierten Anodenemitter (6), eine n dotierte n-Basis (7) und eine p dotierte p-Basis (8) umfassen, wobei der Anodenemitter (6) mit der Anodenelektrode (3) in elektrischem Kontakt und die p-Basis (8) mit der Gateelektrode (5) in elektrischem Kontakt steht und in der p-Basis (8) n+ dotierte Kathodenemittergebiete (9) eingelassen sind, welche mit der Kathodenelektrode (4) in elektrischem Kontakt stehen,
d) der Anodenemitter (6) mit n+ dotierten Anodenkurzschlussgebieten (10) durchsetzt ist und
e) zwischen der n-Basis (7) und dem Anodenemitter (6) eine n dotierte Stopschicht (11) vorgesehen ist, welche stärker dotiert ist als die n-Basis (7);
**dadurch gekennzeichnet, dass**
f) der Anodenemitter (6) als transparenter Emitter ausgeführt ist.

2. Thyristor nach Anspruch 1, **dadurch gekennzeichnet, dass** die Stopschicht (11) eindiffundiert ist und insbesondere eine Tiefe von ca. 20 µm bis 40 µm und eine Randkonzentration von ca. 7*10¹⁴ cm⁻³ aufweist.

3. Thyristor nach Anspruch 1, **dadurch gekennzeichnet, dass** die Stopschicht (11) epitaktisch erzeugt ist und insbesondere eine Tiefe von ca. 20 µm bis 40 µm aufweist.

4. Thyristor nach Anspruch 3, **dadurch gekennzeichnet, dass** die Stopschicht (11) ein homogenes Dotierungsprofil insbesondere mit einer Dotierung von ca. 3*10¹⁴ cm⁻³ aufweist.

5. Thyristor nach Anspruch 3, **dadurch gekennzeichnet, dass** die Stopschicht (11) ein mindestens zweistufiges Dotierungsprofil aufweist, wobei eine erste, von der zweiten Hauptfläche weiter entfernte Stufe (12) stärker dotiert ist und insbesondere eine Dotierung von ca. 10¹⁵ cm⁻³ und eine Tiefe von ca. 10 µm aufweist und eine zweite, direkt an die zweite Hauptfläche (2) grenzende Stufe (13) schwächer dotiert ist und insbesondere eine Dotierung von weniger als ca. 10¹⁴ cm⁻³ und eine Tiefe von ca. 10 µm aufweist.

6. Thyristor nach einen der vorstehenden Ansprüche, **dadurch gekennzeichnet, dass** der transparente Emitter (6) eine Tiefe von ca. 1.2 µm und eine Dotierung von ca. 10¹⁸ cm⁻³ aufweist.

7. Thyristor nach einem der vorstehenden Ansprüche, **dadurch gekennzeichnet, dass** die Anodenkurzschlussgebiete (10) einen geringen Durchmesser von insbesondere 5 µm bis 10 µm aufweisen.

## Revendications

1. Thyristor à blocage par gâchette comprenant :
a) entre une première surface principale (1) et une deuxième surface principale (2), une pluralité de couches semi-conductrices (6-9) de dopages différents ;
b) sur la deuxième surface principale (2), une électrode d'anode (3) ainsi que sur la première surface principale (1), une électrode de cathode (4) et une électrode de grille (5) ;
c) les couches semi-conductrices (6-9) comprenant, vu depuis la deuxième couche principale (2), un émetteur d'anode (6) dopé p+, une base n (7) dopée n et une base p (8) dopée p, l'émetteur d'anode (6) étant en contact électrique avec l'électrode d'anode (3) et la base p (8) étant en contact électrique avec l'électrode de grille (5), et des régions émettrices de cathode (9) dopées n+ étant intégrées dans la base p (8), lesquelles sont en contact électrique avec l'électrode de cathode (4),
d) l'émetteur d'anode (6) étant traversé par des régions de court-circuit d'anode (10) dopées n+ et
e) entre la base n (7) et l'émetteur d'anode (6), une couche d'arrêt (11) dopée n étant prévue, laquelle est plus fortement dopée que la base n (7) ;
**caractérisé en ce que**
f) l'émetteur d'anode (6) est réalisé en tant qu'émetteur transparent.

2. Thyristor selon la revendication 1, **caractérisé en ce que** la couche d'arrêt (11) est diffusée à l'intérieur et présente notamment une profondeur d'environ 20 µm à 40 µm et une concentration marginale d'environ 7 * 10¹⁴ cm⁻³.

3. Thyristor selon la revendication 1, **caractérisé en ce que** la couche d'arrêt (11) est produite par épitaxie et présente notamment une profondeur d'environ 20 µm à 40 µm.

4. Thyristor selon la revendication 3, **caractérisé en ce que** la couche d'arrêt (11) présente un profil de dopage homogène notamment avec un dopage d'environ 3 * 10¹⁴ cm⁻³.

5. Thyristor selon la revendication 3, **caractérisé en ce que** la couche d'arrêt (11) présente un profil de dopage à au moins deux étages, un premier étage (12) plus éloigné de la deuxième surface principale étant plus fortement dopé et présentant notamment un dopage d'environ 10¹⁵ cm⁻³ et une profondeur d'environ 10 µm et un deuxième étage (13) directement adjacent à la deuxième surface principale (2) étant plus faiblement dopé, et présentant notamment un dopage inférieur à environ 10¹⁴ cm⁻³ et une profondeur d'environ 10 µm.

6. Thyristor selon l'une quelconque des revendications précédentes, **caractérisé en ce que** l'émetteur transparent (6) présente une profondeur d'environ 1,2 µm et un dopage d'environ 10¹⁸ cm⁻³.

7. Thyristor selon l'une quelconque des revendications précédentes, **caractérisé en ce que** les régions de court-circuit d'anode (10) présentent un diamètre moins important de notamment 5 µm à 10 µm.

## Claims

1. Gate turn-off thyristor, comprising:
a) between a first main surface (1) and a second main surface (2), a number of differently doped semiconductor layers (6-9);
b) on the second main surface (2), an anode electrode (3) and, on the first main surface (1), a cathode electrode (4) and a gate electrode (5);
c) the semiconductor layers (6-9) comprising, viewed from the second main surface (2), a p⁺-doped anode emitter (6), an n-doped n-base (7) and a p-doped p-base (8), the anode emitter (6) being in electrical contact with the anode electrode (3) and the p-base (8) being in electrical contact with the gate electrode (5), and n⁺-doped cathode-emitter regions (9), which are in electrical contact with the cathode electrode (4), being incorporated in the p-base (8);
d) n⁺-doped anode short-circuit regions (10) penetrating through the anode emitter (6), and
e) an n-doped barrier layer (11) being provided between the n-base (7) and the anode emitter (6), which barrier layer is more highly doped than the n-base (7);
**characterized in that**
f) the anode emitter (6) is designed as a transparent emitter.

2. Thyristor according to Claim 1, **characterized in that** the barrier layer (11) is diffused and, in particular, has a depth of approximately 20 µm to 40 µm and an edge concentration of approximately 7*10¹⁴ cm⁻³.

3. Thyristor according to Claim 1, **characterized in that** the barrier layer (11) is epitaxially produced and, in particular, has a depth of approximately 20 µm to 40 µm.

4. Thyristor according to Claim 3, **characterized in that** the barrier layer (11) has a homogeneous doping profile, in particular with a doping level of approximately 3*10¹⁴ cm⁻³.

5. Thyristor according to Claim 3, **characterized in that** the barrier layer (11) has an at least two-stage doping profile, a first stage (12), further away from the second main surface, being more heavily doped and, in particular, having a doping level of approximately 10¹⁵ cm⁻³ and a depth of approximately 10 µm, and a second stage (13), directly adjoining the second main surface (2), being more lightly doped and, in particular, having a doping level of less than approximately 10¹⁴ cm⁻³ and a depth of approximately 10 µm.

6. Thyristor according to one of the preceding claims, **characterized in that** the transparent emitter (6) has a depth of approximately 1.2 µm and a doping level of approximately 10¹⁸ cm-³.

7. Thyristor according to one of the preceding claims, **characterized in that** the anode short-circuit regions (10) have a small diameter of, in particular, 5 µm to 10 µm.
